# EUROPEAN PATENT APPLICATION

(11) **EP 4 456 121 A1**
(43) Date of publication of application: **30.10.2024**
(21) Application number: 22910829.5
(22) Date of filing: 02.12.2022
(51) Int. Cl.: H01L 21/683, B32B 9/04, B32B 15/04, B32B 15/20, C23C 14/50, H01L 21/205, H01L 21/31

(54) **LAMINATE STRUCTURE, STAGE, SEMICONDUCTOR MANUFACTURING DEVICE, AND MANUFACTURING METHOD FOR LAMINATE STRUCTURE**

(30) Priority: 21.12.2021 JP 2021207546
(71) Applicant: NHK Spring Co., Ltd., Yokohama-shi, Kanagawa 236-0004 (JP)
(72) Inventor: OTSUKA, Yusuke, Yokohama-shi, Kanagawa 236-0004 (JP); KIDA, Naoya, Yokohama-shi, Kanagawa 236-0004 (JP); FUTAKUCHIYA, Jun, Yokohama-shi, Kanagawa 236-0004 (JP); KANEDA, Noriyoshi, Yokohama-shi, Kanagawa 236-0004 (JP); YOKOYAMA, Hibiki, Yokohama-shi, Kanagawa 236-0004 (JP); SONE, Michiyoshi, Yokohama-shi, Kanagawa 236-0004 (JP); SAKAMOTO, Hiroki, Yokohama-shi, Kanagawa 236-0004 (JP)
(74) Representative: dompatent von Kreisler Selting Werner - Partnerschaft von Patent- und Rechtsanwälten mbB
(86) International application number: PCT/JP2022/044537
(87) International publication number: WO 2023/120112

(57) **Abstract**

A laminate structure of the invention is a laminate structure for a semiconductor manufacturing device, and includes a substrate containing aluminum and including a first face, an intermediate layer arranged on the first face of the substrate and containing aluminum oxide, and a cover layer arranged on the intermediate layer and containing metal atoms. The intermediate layer includes a partition wall forming a plurality of voids in a cross-sectional shape parallel to the first face. The intermediate layer includes a boundary layer covering the first face of the substrate. The cover layer is arranged in some of the plurality of voids in the intermediate layer. The plurality of voids includes voids adjacent to the boundary layer and separated from the cover layer.

## Description

### TECHNICAL FIELD

The present invention relates to a laminate structure.

### BACKGROUND ART

A stage in a semiconductor manufacturing device includes an aluminum substrate and an insulating layer formed on a surface thereof. For example, according to a configuration disclosed in Patent Literature 1, an insulating layer includes, for example, an aluminum oxide layer (alumite layer) formed on the substrate by anodic oxidation and aluminum oxide (alumina cover layer) formed by thermal spraying. It is not possible to obtain good adhesion between the alumite layer and the alumina cover layer. Therefore, it is necessary to roughen a surface of the alumite layer by performing a blasting treatment on the surface of the alumite layer, thereby improving adhesion of the alumina cover layer.

### CITATION LIST

### PATENT LITERATURE

Patent Literature 1: Japanese Laid-Open Patent Publication No. 2000-114189

### SUMMARY OF INVENTION

### TECHNICAL PROBLEM

According to a configuration of Patent Literature 1, adhesion between an alumite layer and an alumina thermally sprayed layer is improved by scraping off about 10 µm by a physical roughening treatment such as a blasting treatment on the alumite layer of about 30 µm. Forming an alumite layer having a thickness sufficient to withstand roughening such as the blasting treatment requires a long manufacturing time. Further, since a process such as scraping off the alumite layer by the blasting treatment is also required, a longer manufacturing time is required. Further, when a substrate is exposed by the roughening treatment, an exposed portion may adversely affect a withstand voltage. Therefore, in order to reduce manufacturing defects, the alumite layer may have to be further thickened.

An object of the present invention is to improve adhesion of the cover layer without performing a physical roughening treatment such as the blasting treatment.

### SOLUTION TO PROBLEM

According to an embodiment, there is provided a laminate structure for a semiconductor manufacturing device, the laminate structure including a substrate containing aluminum and including a first face, an intermediate layer arranged on the first face of the substrate and containing aluminum oxide, and a cover layer arranged on the intermediate layer and containing metal atoms. The intermediate layer includes a partition wall forming a plurality of voids in a cross-sectional shape parallel to the first face. The intermediate layer includes a boundary layer covering the first face of the substrate. The cover layer is arranged in some of the plurality of voids in the intermediate layer. The plurality of voids includes voids adjacent to the boundary layer and separated from the cover layer.

The plurality of voids may include a first void and a second void adjacent to the first void, a first diameter of the first void is 10 nm or more and 100 nm or less, and a second diameter of the second void is 1.5 times larger than the first diameter.

The first diameter may be 10 nm or more and 30 nm or less.

A thickness of the partition wall between the first void and the second void may be less than a length of the first diameter of the first void.

The partition wall may include a mesh structure.

The thickness of the intermediate layer may be 2 µm or less, an adhesion strength between the cover layer and the intermediate layer may be greater than a breaking strength of the cover layer, and a withstand voltage of the intermediate layer and the cover layer may be 28 kVDC/mm or more.

According to an embodiment, there is provided a laminate structure for a semiconductor manufacturing device, the laminate structure including a substrate containing aluminum and including a first face, an intermediate layer arranged on the first face of the substrate and containing aluminum oxide, and a cover layer arranged on the intermediate layer and containing metal atoms. The intermediate layer includes a partition wall forming a plurality of voids in a cross-sectional shape parallel to the first face. The plurality of voids includes a first void having a first diameter and a second void having a second diameter adjacent to the first void. The first diameter is 10 nm or more and 30 nm or less, and the second diameter is 1.5 times larger than the first diameter.

According to an embodiment, there is provided a laminate structure for a semiconductor manufacturing device, the laminate structure including a substrate containing aluminum and including a first face, an intermediate layer arranged on the first face of the substrate and containing aluminum oxide, and a cover layer arranged on the intermediate layer and containing metal atoms. The intermediate layer includes a partition wall forming a plurality of voids in a cross-sectional shape parallel to the first face, the plurality of voids includes a first void having a first diameter and a second void adjacent to the first void, and a thickness of the partition wall between the first void and the second void is less than a length of the first diameter.

According to an embodiment, there is provided a laminate structure for a semiconductor manufacturing device, the laminate structure including a substrate containing aluminum and including a first face, an intermediate layer arranged on the first face of the substrate and containing aluminum oxide, and a cover layer arranged on the intermediate layer and containing metal atoms. The intermediate layer includes a mesh partition wall forming a plurality of voids in a cross-sectional shape parallel to the first face.

According to an embodiment, there is provided a laminate structure for a semiconductor manufacturing device, the laminate structure including a substrate containing aluminum and including a first face, an intermediate layer arranged on the first face of the substrate and containing aluminum oxide, and a cover layer arranged on the intermediate layer and containing metal atoms. The intermediate layer includes a partition wall forming a plurality of voids in a cross-sectional shape parallel to the first face, and a thickness of the intermediate layer is 2 µm or less. An adhesion strength between the cover layer and the intermediate layer is greater than a breaking strength of the cover layer. A withstand voltage of the intermediate layer and the cover layer is 28 kVDC/mm or more.

An adhesion strength between the substrate and the cover layer may be 20 MPa or higher.

The partition wall may have a portion extending perpendicular to the first face, and the void may have a portion extending perpendicular to the first face.

The metal atoms may be aluminum.

The cover layer may contain aluminum oxide.

The cover layer may be a layer of a thermally sprayed film.

According to an embodiment, there is provided a stage including the laminate structure described above, wherein the cover layer is an insulator, and the stage has a region where the cover layer is not formed at least in part of the substrate on a second face opposite to the first face.

According to an embodiment, there is provided a semiconductor manufacturing device including the stage described above and a chamber in which the stage is arranged.

An electrode for generating plasma in the chamber may be further included.

According to an embodiment, there is provided a manufacturing method of a laminate structure for a semiconductor manufacturing device, the method including oxidizing a substrate containing aluminum to form an intermediate layer containing aluminum oxide including a plurality of voids on a first face of the substrate and forming a cover layer containing metal atoms by thermal spraying on the intermediate layer so as to penetrate into some of the plurality of voids.

A thickness of the intermediate layer may be 2 µm or less.

### ADVANTAGEOUS EFFECTS OF INVENTION

According to the present invention, it is possible to improve the adhesion of the cover layer without performing a physical roughening treatment such as a blasting treatment.

### BRIEF DESCRIPTION OF DRAWINGS

FIG. 1 is a diagram showing a semiconductor manufacturing device according to an embodiment.
FIG. 2 is a diagram schematically showing a cross-sectional structure in a vicinity of a surface of a stage in an embodiment.
FIG. 3 is a flowchart for explaining a manufacturing method of a stage according to an embodiment.
FIG. 4 is a diagram for explaining a manufacturing method of a stage according to an embodiment.
FIG. 5 is a diagram for explaining a manufacturing method of a stage according to an embodiment.
FIG. 6 is a SEM photograph showing a surface structure of an intermediate layer according to an embodiment.
FIG. 7 is a diagram for describing features of a surface structure of an intermediate layer according to an embodiment.
FIG. 8 is a SEM photograph showing a cross-sectional structure after forming an intermediate layer according to an embodiment.
FIG. 9 is a SEM photograph showing a cross-sectional structure after forming a cover layer according to an embodiment.
FIG. 10 is a diagram for explaining a result of a tensile test on a sample in which a cover layer is formed on a surface of a substrate subjected to a roughening treatment.
FIG. 11 is a diagram for explaining a result of a tensile test on a sample in which a cover layer is formed on an intermediate layer formed on a substrate.
FIG. 12 is a SEM photograph showing a surface structure of an intermediate layer according to a modification.

### DESCRIPTION OF EMBODIMENTS

Hereinafter, an embodiment of the present invention will be described in detail with reference to the drawings. The following embodiments are examples, and the present invention should not be construed as being limited to these embodiments. In the drawings referred to in the present embodiment, parts having the same or similar functions are denoted by the same reference signs or similar reference signs (only denoted by A, B, or the like after the numerals), and repetitive description thereof may be omitted. In the drawings, dimensional ratios may be different from actual ratios, or a part of the configuration may be omitted from the drawings for clarity of explanation.

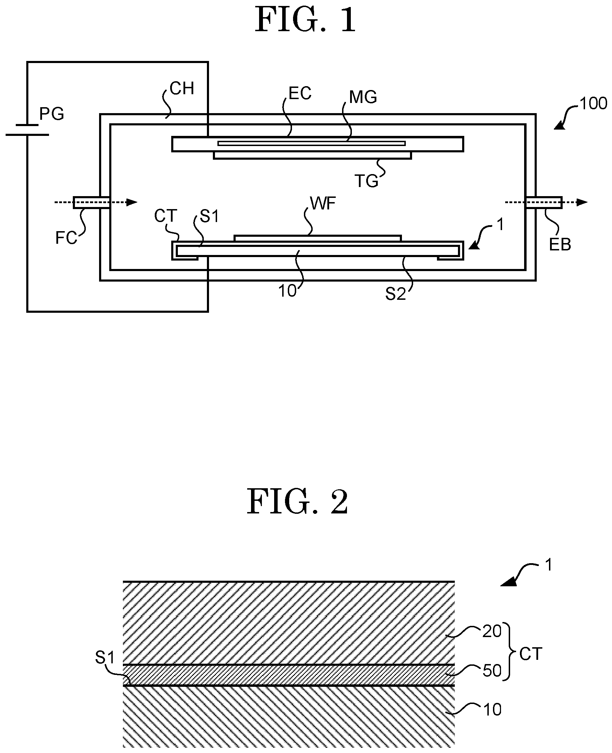

FIG. 1 is a diagram showing a semiconductor manufacturing device according to an embodiment. A semiconductor manufacturing device 100 shown in FIG. 1 is, for example, a sputtering device. The semiconductor manufacturing device may be a PVD (Physical Vapor Deposition) device or a CVD (Chemical Vapor Deposition) device other than the sputtering device. The semiconductor manufacturing device 100 is not limited to a device having an electrode for generating plasma, and may be a device that does not generate plasma.

The semiconductor manufacturing device 100 includes a stage 1, an electrode EC, and a chamber CH containing the stage 1 and the electrode EC. The chamber CH includes an inlet FC for introducing gas into an interior of the chamber CH and an outlet EB for discharging gas. The stage 1 has a first face S1 for mounting a semiconductor wafer WF. The electrode EC has a magnet MG therein. A target TG is attached to the electrode EC.

The stage 1 includes a substrate 10 and an insulating layer CT that covers a portion of a surface of the substrate 10 to expose a part of the substrate 10. The substrate 10 is a conductor, and in this example, is aluminum. For example, the insulating layer CT covers a portion of the first face S1 to a second face S2 while covering the first face S1 of the substrate 10, and expose a portion of the second face S2 of the substrate 10. That is, the insulating layer CT is not formed on a portion of the second face S2 of the substrate 10. The second face S2 is a surface arranged on the opposite side of the first face S1. The electrode EC and the substrate 10 generate plasma inside the chamber CH by connecting a power supply PG to the substrate 10 and the electrode EC.

The stage 1 may have a heating function or a cooling function. In the case of a heating function, a heating element may be arranged inside the substrate 10, or in the case of a cooling function, a pipe to pass a refrigerant may be arranged inside the substrate 10.

Next, a relationship between the substrate 10 and the insulating layer CT in the stage 1 will be described.

FIG. 2 is a diagram schematically showing a cross-sectional structure in a vicinity of a surface of a stage in an embodiment. As shown in FIG. 2, the insulating layer CT is arranged on the first face S1 of the substrate 10. The insulating layer CT is an exemplary laminate structure including an intermediate layer 50 on the substrate 10 and a cover layer 20 arranged on the intermediate layer 50.

As described above, the substrate 10 is a conductor, and in this example, is aluminum. The intermediate layer 50 is a layer of aluminum oxide formed by oxidizing the surface of the substrate 10. The cover layer 20 is a layer of a thermally sprayed film containing metal atoms formed on the intermediate layer 50 by thermal spraying, and in this example is a layer of aluminum oxide which is an insulator.

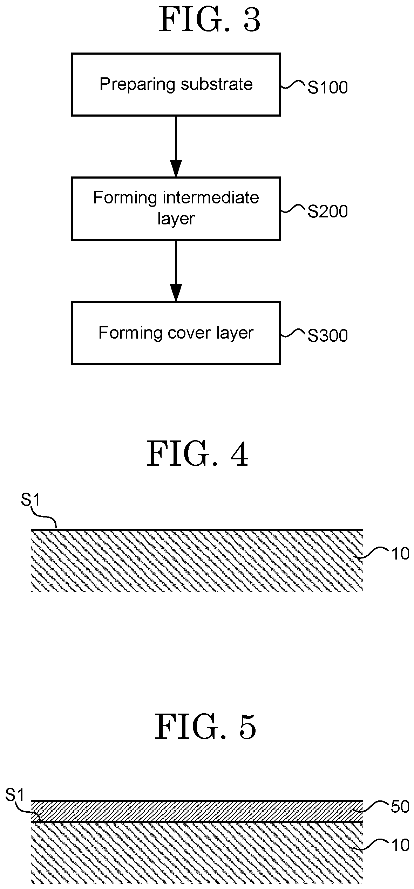

FIG. 3 is a flowchart showing a manufacturing method of a stage according to an embodiment. FIG. 4 and FIG. 5 are diagrams for explaining a manufacturing method of a stage according to an embodiment. First, as shown in FIG. 4, the substrate 10 is prepared (step S100). In this example, the substrate 10 is aluminum. Subsequently, as shown in FIG. 5, an intermediate layer 50 is formed by oxidizing the surface of the substrate 10 (Step S200). Here, aluminum oxide is formed on the surface of the substrate 10 (the first face S1 in the case of FIG. 5) by anodic oxidation. A layer of aluminum oxide formed in this way corresponds to the intermediate layer 50. A thickness of the intermediate layer 50 is, for example, 0.1 µm or more and 2 µm or less, preferably 0.3 µm or more and 1.5 µm or less, and more preferably 0.5 µm or more and 1.2 µm or less.

Although the anodic oxidation can be performed by various known methods, the conditions are appropriately set so as to form the intermediate layer 50 satisfying at least a part of the conditions described later. For example, an oxidation treatment is realized by immersing a portion of the substrate 10 forming the intermediate layer 50 in an electrolytic solution in an exposed state, applying a predetermined voltage using the substrate 10 as an anode, and flowing a current from the substrate 10 to a counter electrode. An AC voltage may be applied to the substrate 10.

The electrolytic solution is, for example, phosphoric acid, and an acidic electrolytic solution such as sulfuric acid, nitric acid, or oxalic acid may be used, or an alkaline electrolytic solution may be used. A solution or a surfactant having an action of dissolving aluminum oxide may be added to the electrolytic solution. The temperature of the electrolytic solution may be appropriately set, but is set to, for example, about 20 degrees. If the temperature is too low, a partition wall becomes thicker, so-called hard alumite, but as will be described later, the partition wall in the intermediate layer 50 is preferably thin, and therefore, it may be set to a temperature of 20 degrees or more, for example, 25 degrees or more and 40 degrees or less.

Before the oxidation treatment, a pretreatment for cleaning the surface of the substrate 10, for example, a degreasing treatment, a treatment such as removal of an oxide by immersion in a mixed acid containing phosphoric acid, sulfuric acid, and nitric acid, or immersion in an aqueous sodium hydroxide solution may be performed. After the oxidation treatment, a thinning treatment of the partition wall with an aqueous sodium hydroxide solution may be performed.

The laminate structure of the stage 1 shown in FIG. 2 is formed by forming the cover layer 20 with respect to the intermediate layer 50 formed in this way (step S300). The cover layer 20 is formed by thermal spraying aluminum oxide.

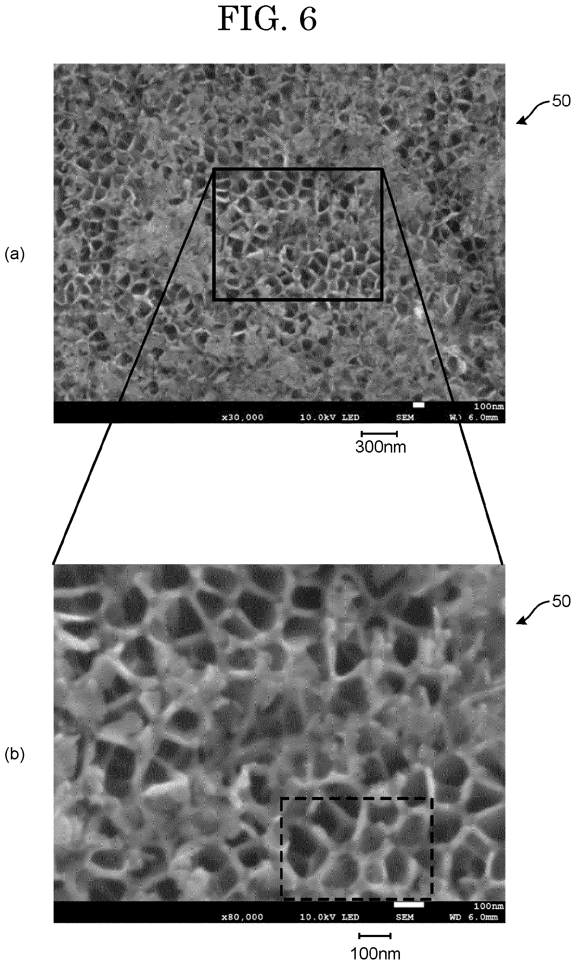

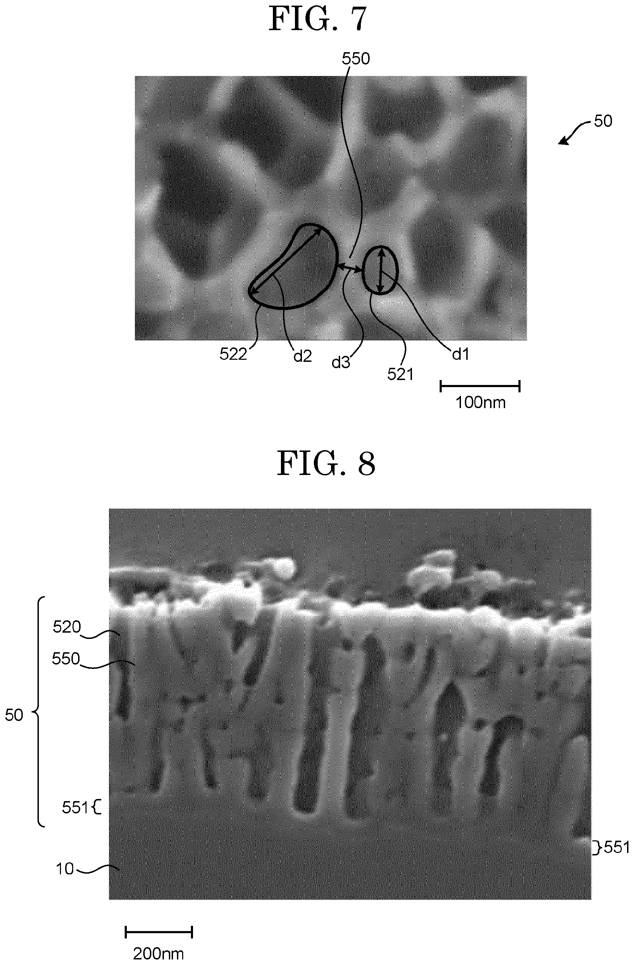

A structure of the intermediate layer 50 will be described with reference to FIG. 6, FIG. 7, and FIG. 8. First, a surface structure when the intermediate layer 50 is formed will be described with reference to FIG. 6 and FIG. 7. Features of the surface structure are not only features that appear only on a surface of the intermediate layer 50, but also similar features in a portion of a cross section of the intermediate layer 50 that is parallel to the first face S1.

FIG. 6 is a SEM photograph showing a surface structure of an intermediate layer in an embodiment. A SEM photograph (b) in FIG. 6 is a photograph obtained by enlarging a part (a region surrounded by a solid line) of a SEM photograph (a). As shown in FIG. 6, the intermediate layer 50 includes a partition wall that forms a plurality of voids in a cross-sectional shape that are parallel to the first face S1. The partition wall forms a three-dimensional mesh structure.

FIG. 7 is a diagram for describing features of a surface structure of an intermediate layer according to an embodiment. FIG. 7 is an enlarged photograph of a region surrounded by a dashed line in the SEM photograph (b) of FIG. 6. A void 521 (first void) and a void 522 (second void) are adjacent to each other via a partition wall 550. In the case where the void 521 and the void 522 are described without being distinguished from each other, they may be represented as a void 520.

A diameter of a void is a length connecting two points at an outer edge of the void in a cross section parallel to the first face S1, and is a value when the length is the largest. In this example, although a diameter d1 of the void 521 is about 50 nm in the example shown in FIG. 7, the diameter d1 may be 5 nm or more and 200 nm or less. The diameter d1 (first diameter) of the void 521 is preferably 10 nm or more and 100 nm or less. The diameter d1 of the void 521 may be 10 nm or more and 30 nm or less. Although a diameter d2 (second diameter) of the void 522 is about 110 nm in the embodiment shown in FIG. 7, the diameter d2 is 1.5 times larger or more than the diameter d1 of the void 521. As described above, in the intermediate layer 50, at least some of a plurality of voids 520 (for example, the void 521 described above) have a large difference in diameter from adjacent voids (for example, the void 522 described above).

A thickness d3 of a thinnest portion of the partition wall 550 sandwiched between the void 521 and the void 522 is about 30 nm in the example shown in FIG. 7, and is smaller than a length of the smaller diameter of the void 521 and the void 522 (here, the diameter d1) partitioned by the partition wall 550. As described above, in the intermediate layer 50, a plurality of voids are formed by the thin partition walls 550.

FIG. 8 is a SEM photograph showing a cross-sectional structure after forming an intermediate layer according to an embodiment. The intermediate layer 50 includes a boundary layer 551 at a boundary portion with the substrate 10. The boundary layer 551 may be generally referred to as a barrier layer. The partition wall 550 includes a portion extending from the interface layer 551 and includes a portion extending perpendicular to the first face S1 of the substrate 10. The void 520 includes a portion extending perpendicular to the first face S1 of the substrate. Perpendicular does not necessarily mean 90 degrees, but may have a range of several degrees.

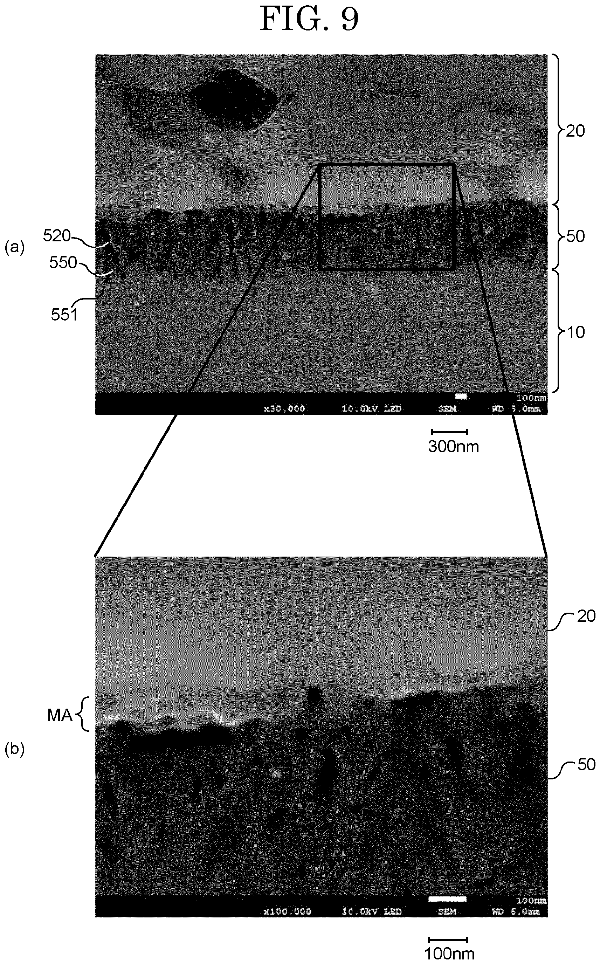

Next, a relationship between the intermediate layer 50 and the cover layer 20 after the cover layer 20 is formed will be described with reference to FIG. 9.

FIG. 9 is a SEM photograph showing a cross-sectional structure after forming a cover layer according to an embodiment. A SEM photograph (b) in FIG. 9 is a photograph obtained by enlarging a part (a region surrounded by a line) of a SEM photograph (a). A region MA is formed at a border between the intermediate layer 50 and the cover layer 20. The region MA is formed by penetration of the aluminum oxide to be thermally sprayed into a part of the voids when the cover layer 20 is formed. A depth of penetration of the cover layer 20 is from about 50 nm to 80 nm even in a deep part. Therefore, the cover layer 20 penetrates only the voids 520 existing in a small portion on a front surface side (cover layer 20 side) of the intermediate layer 50.

In other words, a thickness of the region MA is much smaller than the thickness of the intermediate layer 50, and the voids 520 in which the cover layer 20 does not penetrate remains in most parts of the intermediate layer 50. That is, even after the cover layer 20 is formed, the intermediate layer 50 has voids 520 adjacent to the boundary layer 551 and spaced apart from the cover layer 20. The presence of the voids 520 provides a stress relaxation effect. If the intermediate layer 50 is 0.1 µm or more, there may be voids 520 in which the cover layer 20 does not penetrate. In particular, since thermal spraying at the time of formation of the cover layer 20 is exposed to a high temperature state, even if a large stress is generated due to such a temperature change, the stress is relieved by the presence of the voids 520.

Subsequently, adhesion of the substrate 10, the intermediate layer 50 and the cover layer 20 formed in this way and a withstand voltage between the substrate 10 and a surface of the cover layer 20 are evaluated. As a comparative example, instead of using the intermediate layer 50, a sample obtained by roughening the substrate 10 in order to improve adhesion was used. Adhesion was confirmed by a tensile test. The tensile test was performed according to ASTM C633. A withstand voltage test was performed with reference to JIS C2110.

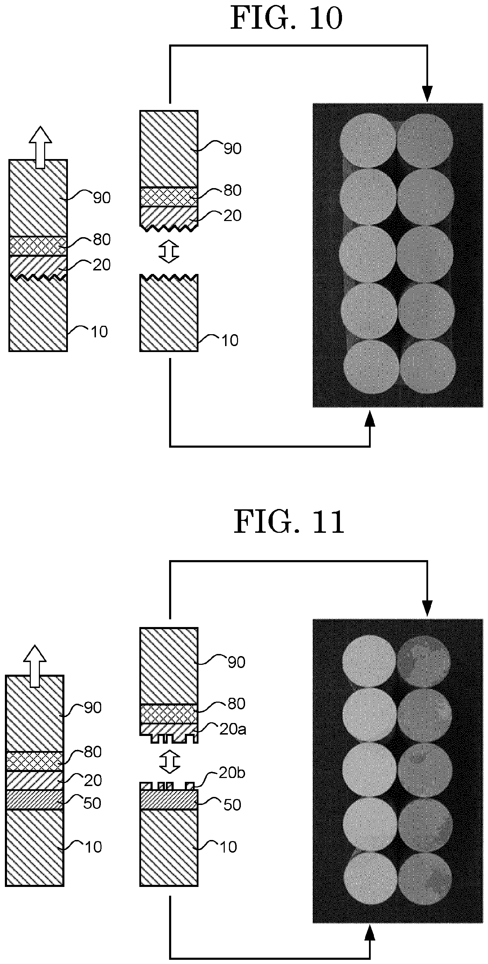

FIG. 10 is a diagram for explaining a result of a tensile test on a sample in which a cover layer is formed on a surface of a substrate subjected to a roughening treatment. Here, as a configuration of a comparative example, roughening treatment (a concave-convex formation of about 100 µm) was performed on the substrate 10, and the cover layer 20 was formed by thermal spraying. That is, the conventional technique differs from the example in the embodiment described above in that the intermediate layer 50 is not present and the substrate 10 has a surface roughened by a blasting treatment. A support rod 90 was attached to the cover layer 20 using an adhesive 80, and the support rod 90 and the substrate 10 were fixed to a tensile tester. As a result of the tensile test on samples of the comparative example, all the samples (10 samples, 5 samples of which are exemplified in the photograph shown in FIG. 10) were broken at a boundary between the substrate 10 and the cover layer 20. A strength when the sample broke, that is, an adhesion strength, of all of the samples was less than 20 MPa, and an average of 10 samples was 17 MPa.

As a result of the withstand voltage test with respect to the samples of the comparative example, the withstand voltages of the cover layers 20 were all less than 28 kVDC/mm. Due to the presence of protrusions on the surface of the substrate 10, it is considered that a peak of the protrusion is a factor that lowers the withstand voltage.

FIG. 11 is a diagram for explaining a result of a tensile test on samples in which a cover layer is formed on an intermediate layer formed on a substrate. Here, as a configuration in the embodiment described above, the intermediate layer 50 is formed on the substrate 10, and the cover layer 20 is further formed by thermal spraying. The support rod 90 was attached to the cover layer 20 using the adhesive 80, and the support rod 90 and the substrate 10 were fixed to the tensile tester. As a result of the tensile test on the samples in this embodiment, all samples (10 samples, 5 samples of which are shown in the photograph shown in FIG. 11) were broken at a boundary between the cover layer 20 and the intermediate layer 50 and inside the cover layer 20. A strength when the sample broke, that is, an adhesion strength of all of the samples was 17 MPa, and an average of 10 samples was 22 MPa. The adhesion strength of most of the samples became 20 MPa or more which is equal to or more than a maximal adhesion strength obtained in the sample of the comparative example. That is, it is possible to easily realize that the adhesion strength is 20 MPa or more by providing the intermediate layers 50 as in the embodiment described above. The adhesion strength is more preferably 22 MPa or more. Since the cover layer 20 includes breakage, the adhesion strength between the cover layer 20 and the intermediate layer 50 may be greater than a breaking strength of the cover layer 20.

As a result of the withstand voltage test on the samples in this embodiment, withstand voltages of the laminates of the intermediate layer 50 and the cover layer 20 were both 28 kVDC/mm or more.

The sample in which the intermediate layer 50 was formed as described above had a higher adhesion strength and a higher withstand voltage than the sample in which the roughening treatment was used. Since the intermediate layer 50 has a structure satisfying at least a part of the conditions described above, the adhesion strength can be improved as compared with the case where the roughening treatment is performed. In particular, if the cover layer 20 is formed by thermal spraying in a state in which the void 520 of the intermediate layer 50 is exposed on the surface, the cover layer 20 slightly penetrates the void 520, and even if the cover layer 20 is a layer that is much thinner than a depth of a concave-convex part having an effect on the roughening treatment, the adhesion strength can be increased as compared with the case where the roughening treatment was performed.

In this case, the intermediate layer 50 only needs to satisfy at least one of a condition of having a void 520 formed by the partition wall 550 thinner than a diameter of the void 520, a condition of including a void 520 that satisfies a condition that a diameter of an adjacent void 520 differs by 1.5 times or more, or a condition that the partition wall 550 has a mesh structure, and may satisfy a plurality of conditions. Adhesion can be further improved by satisfying a plurality of conditions.

In the case of forming an organic resin on an aluminum substrate, a technique for enhancing adhesion by forming an oxide film having voids in advance by subjecting the substrate surface to an oxidation treatment has been known in the art. Such an organic resin is first applied to the surface of the substrate in liquid form. In this case, the applied material penetrates so as to fill all voids in the oxide film. Therefore, no voids remain in the oxide film, and all of the voids are filled with the organic resin. In this case, it has been recognized that in the case where an amount of penetration of the organic resin into the voids is small, adhesion is lowered. Further, in the case where an organic resin is used, a step of curing the applied liquid material by heat treatment is included.

On the other hand, when the cover layer 20 is formed by thermal spraying, the thermally sprayed particles solidify as soon as they come into contact with the intermediate layer 50, and therefore penetrate only a part of the surface of the void 520 of the intermediate layer 50. In this way, the organic resin and an inorganic material formed by thermal spraying or the like are completely different from each other in the manufacturing state.

Further, in the case of forming the cover layer by thermal spraying, as also shown in Patent Literature 1 described above, even if the oxide film is formed, a material formed by thermal spraying has poor adhesion, and it was a general technique to perform the roughening treatment. Therefore, even in the case of forming an oxide film as in Patent Literature 1, it was necessary to form a film thick enough to withstand roughening.

As described above, it has not been envisaged by an ordinary engineer to apply a thin oxide film used for improving adhesion between an organic resin and a substrate in order to improve adhesion between a material formed by thermal spraying and a substrate. The present inventors have found for the first time that adhesion of a layer formed by thermal spraying can be improved even with such a thin oxide film by a new viewpoint. However, as described above, in the case of an organic resin, adhesion is improved by penetrating into the voids of the oxide film, since a layer formed by thermal spraying only slightly penetrates into the voids, principles of improving the adhesion may be different from each other.

### <Modification>

The present disclosure is not limited to the embodiments described above, and includes various other modifications. For example, the embodiments described above have been described in detail for the purpose of showing the present disclosure in an easy-to-understand manner, and are not necessarily limited to those having all the described configurations. Further, it is possible to add, delete, or replace a part of the configuration of each embodiment with another configuration. Some modifications will be described below.

(1) The structure of the intermediate layer 50 can be variously changed by adjusting the manufacturing conditions.

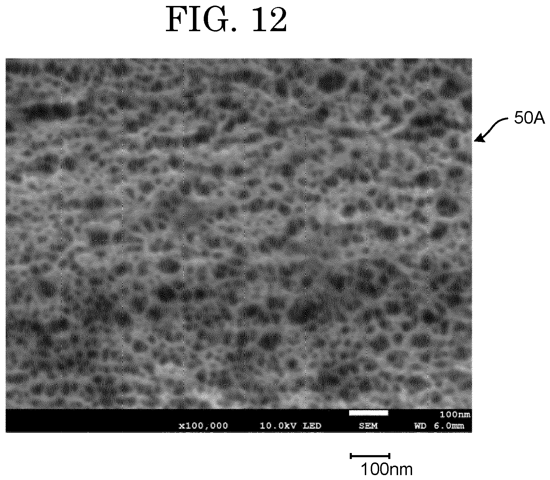

   FIG. 12 is a SEM photograph showing a surface structure of an intermediate layer according to a modification. When the substrate 10 is oxidized under a condition other than the embodiment described above, an intermediate layer 50A of the modification shown in FIG. 12 has a surface structure including a partition wall of a three-dimensional mesh structure the same as the intermediate layer 50. On the other hand, as compared with the intermediate layer 50 shown in FIG. 6 in an embodiment, the intermediate layer 50A is controlled to have a smaller diameter of a void as a whole, and has a larger number of voids having a diameter of 10 nm or more and 30 nm or less. Even in the intermediate layer 50A having such a surface structure, the cover layer 20 formed by thermal spraying can slightly penetrate into the voids appearing on the surface, and the same advantages as those of the intermediate layer 50 in the embodiment can be obtained.
(2) Although a laminate structure including the substrate 10, the intermediate layer 50, and the cover layer 20 is applied to the stage 1 in the semiconductor manufacturing device 100 in the embodiment described above, the laminate structure may be used in a different application from the stage 1. In particular, the laminate structure can be applied as a method for increasing an adhesion strength when a substrate is covered by thermal spraying. Depending on the application, the cover layer 20 may be made from an insulating material other than aluminum oxide, a conductive material, or a layer containing metal atoms such as those covered by thermal spraying. The cover layer 20 may be, for example, yttrium oxide, yttrium oxyfluoride, nickel chromium, or nickel aluminum.

### REFERENCES SIGNS LIST

1: stage, 10: substrate, 20: cover layer, 50, 50A: intermediate layer, 80: adhesive, 90: support rod, 100: semiconductor manufacturing device, 520, 521, 522: void, 550: partition wall, 551: boundary layer

## Claims

1. A laminate structure for a semiconductor manufacturing device comprising:
a substrate containing aluminum and including a first face;
an intermediate layer arranged on the first face of the substrate and containing aluminum oxide; and
a cover layer arranged on the intermediate layer and containing metal atoms, wherein
the intermediate layer includes a partition wall forming a plurality of voids in a cross-sectional shape parallel to the first face,
the intermediate layer includes a boundary layer covering the first face of the substrate,
the cover layer is arranged in some of the plurality of voids in the intermediate layer, and
the plurality of voids includes voids adjacent to the boundary layer and separated from the cover layer.

2. The laminate structure according to claim 1, wherein
the plurality of voids includes a first void and a second void adjacent to the first void,
a diameter of the first void is 10 nm or more and 100 nm or less, and
a diameter of the second void is 1.5 times larger than the diameter of the first void.

3. The laminate structure according to claim 2, wherein
the diameter of the first void is 10 nm or more and 30 nm or less.

4. The laminate structure according to claim 2, wherein
a thickness of the partition wall between the first void and the second void is less than a length of the diameter of the first void.

5. The laminate structure according to claim 1, wherein
the partition wall includes a mesh structure.

6. The laminate structure according to claim 1, wherein
a thickness of the intermediate layer is 2 µm or less,
an adhesion strength between the cover layer and the intermediate layer is greater than a breaking strength of the cover layer, and
a withstand voltage of the intermediate layer and the cover layer is 28 kVDC/mm or more.

7. A laminate structure for a semiconductor manufacturing device comprising:
a substrate containing aluminum and including a first face;
an intermediate layer arranged on the first face of the substrate and containing aluminum oxide; and
a cover layer arranged on the intermediate layer and containing metal atoms, wherein
the intermediate layer includes a partition wall forming a plurality of voids in a cross-sectional shape parallel to the first face,
the plurality of voids includes a first void and a second void adjacent to the first void,
a diameter of the first void is 10 nm or more and 30 nm or less, and
a diameter of the second void is 1.5 times larger than the diameter of the first void.

8. A laminate structure for a semiconductor manufacturing device comprising:
a substrate containing aluminum and including a first face;
an intermediate layer arranged on the first face of the substrate and containing aluminum oxide; and
a cover layer arranged on the intermediate layer and containing metal atoms, wherein
the intermediate layer includes a partition wall forming a plurality of voids in a cross-sectional shape parallel to the first face,
the plurality of voids includes a first void and a second void adjacent to the first void, and
a thickness of the partition wall between the first void and the second void is less than a length of a diameter of the first void.

9. A laminate structure for a semiconductor manufacturing device comprising:
a substrate containing aluminum and including a first face;
an intermediate layer arranged on the first face of the substrate and containing aluminum oxide; and
a cover layer arranged on the intermediate layer and containing metal atoms, wherein
the intermediate layer includes a mesh partition wall forming a plurality of voids in a cross-sectional shape parallel to the first face.

10. A laminate structure for a semiconductor manufacturing device comprising:
a substrate containing aluminum and including a first face;
an intermediate layer arranged on the first face of the substrate and containing aluminum oxide; and
a cover layer arranged on the intermediate layer and containing metal atoms, wherein
the intermediate layer includes a partition wall forming a plurality of voids in a cross-sectional shape parallel to the first face,
a thickness of the intermediate layer is 2 µm or less,
an adhesion strength between the cover layer and the intermediate layer is greater than a breaking strength of the cover layer, and
a withstand voltage of the intermediate layer and the cover layer is 28 kVDC/mm or more.

11. The laminate structure according to claim 1, wherein
an adhesion strength between the substrate and the cover layer is 20 MPa or more.

12. The laminate structure according to claim 1, wherein
the partition wall has a portion extending perpendicular to the first face, and
each of the plurality of voids has a portion extending perpendicular to the first face.

13. The laminate structure according to claim 1, wherein
the metal atoms are aluminum.

14. The laminate structure according to claim 13, wherein
the cover layer contains aluminum oxide.

15. The laminate structure according to claim 1, wherein
the cover layer is a layer of a thermally sprayed film.

16. A stage comprising:
the laminate structure according to claim 1, wherein
the cover layer is an insulator, and
the stage has a region where the cover layer is not formed at least in part of the substrate on a second face opposite to the first face.

17. A semiconductor manufacturing device comprising:
the stage according to claim 16; and
a chamber in which the stage is arranged.

18. The semiconductor manufacturing device according to claim 17, further comprising:
an electrode for generating plasma in the chamber.

19. A manufacturing method for a laminate structure for a semiconductor manufacturing device comprising:
oxidizing a substrate containing aluminum to form an intermediate layer containing aluminum oxide including a plurality of voids on a first face of the substrate; and
forming a cover layer containing metal atoms by thermal spraying on the intermediate layer so as to penetrate into some of the plurality of voids.

20. The manufacturing method for a laminate structure according to claim 19, wherein
a thickness of the intermediate layer is 2 µm or less.
